# EUROPEAN PATENT APPLICATION

(11) **EP 2 320 339 A1**
(43) Date of publication of application: **11.05.2011**
(21) Application number: 09797860.5
(22) Date of filing: 09.07.2009
(51) Int. Cl.: G06F 17/50

(54) **PRODUCT DESIGN EVALUATION DEVICE AND PRODUCT DESIGN EVALUATION PROGRAM**

(30) Priority: 18.07.2008 JP 2008187600; 19.12.2008 JP 2008324563
(71) Applicant: Panasonic Electric Works Co., Ltd., Kadoma-shi Osaka 571-8686 (JP)
(72) Inventor: VEETTIL, Hareesh Puthiya, Osaka 571-8686 (JP)
(74) Representative: Appelt, Christian W.
(86) International application number: PCT/JP2009/062519
(87) International publication number: WO 2010/007935

(57) **Abstract**

In a virtual space, a digital human is connected to a movable portion of a virtual model of a product, and torque acting on each joint of the digital human when the digital human moves the movable portion is calculated in a load calculator 14. The load calculator 14 calculates maximum voluntary contraction according to the angle of each joint based on the relation between the joint angle and maximum voluntary force and separates the workability degree at the time of moving the movable portion of the product into a plurality of levels based on the ratio thereof to the maximum voluntary contraction. The evaluation image generator 15 calculates torque acting on each joint when the digital human moves the movable portion of the product and displays which level the calculated torque belongs to on the screen of the monitor unit 32. The muscular load when the digital human uses the product is then evaluated for assisting design of the product.

## Description

### Technical Field

The present invention relates to a system evaluating designs of mainly products of housing-related equipment. Specifically, the present invention relates to product design evaluation system and program configured to display a designed product with a digital human in a virtual space displayed as a three-dimensional computer graphic image and cause the digital human to use the product for evaluating the design of the product focusing on load acting on each part of the digital human.

### Background Art

In conventional propositions, a product is evaluated by placing a virtual model of the product in a virtual space displayed as a three-dimensional computer graphic image and performing a simulation that the virtual model of the product is used by a digital human (for example, see Patent Literature 1).

Patent Literature 1 describes a technique of specifying a posture of a digital human who is using a virtual model of a product and evaluating the degree of load acting on a target muscle of the digital human assuming such a posture for evaluating the handling performance of the product and assisting design of the product.

### Prior Document

### Patent Literature

Patent Literature 1 : Japanese Patent Laid-open Publication No. 2007-334446

### Summary of Invention

### Problems to be Solved by Invention

The configuration described in Patent Literature 1 evaluates the handling performance of the product based on the posture of the digital human who is using the product basically placed at a fixed position. Accordingly, the configuration described in Patent Literature 1 does not consider evaluation of products including movable portions.

For example, products including movable portions requiring opening up and closing down operations such as toilet lids and products including movable portions requiring up and down operations such as movable shelves provided for hanging cupboards need evaluation in terms of a change in load accompanied with movement of a movable portion as well as in terms of the particular posture. However, such evaluation is not considered in the technique described in Patent Literature 1.

The present invention was made in the light of the aforementioned issue, and an object of the invention is to provide product design evaluation system and program capable of evaluating the design of a product including a movable portion by evaluating load on a user who is using the product including the movable portion.

### Means for Solving Problem

The invention of claim 1 is a product design evaluation system which locates a virtual model based on a design of a product including a movable portion and a digital human moving the movable portion of the virtual model of the product in a virtual space generated by a computer to evaluate the validity of the design of the product based on movement of the digital human, the system including: a data synthesizing unit connecting the movable portion of the virtual model of the product and the digital human and specifying the movement trajectory of the movable portion; and a load calculator calculating load acting on a portion of interest in the digital human when the movable portion is moved along the movement trajectory.

According to the invention of claim 2, a mass entry unit is further provided for the invention of claim 1, the unit setting a mass of the movable portion of the virtual model of the product.

According to the invention of claim 3, a trajectory entry unit is further provided for the invention of claim 1 or 2, the unit specifying the movement trajectory of a portion connecting the movable portion of the virtual model of the product and the digital human.

According to the invention of claim 4, an evaluation image generator and a monitor unit are further provided for the invention of any one of claims 1 to 3, the evaluation image generator generating an image of a graph chart distinctively showing loads acting on portions of interest of the digital human for each portion and showing workability degrees each calculated from the ratio of the magnitude of the load to the maximum voluntary contraction at each portion; and the monitor unit displaying the graph chart generated by the evaluation image generator.

According to the invention of claim 5, in the invention of claim 4, the evaluation image generator generates an image of a graph chart showing a change in load at each position on the movement trajectory for a portion selected from the portions of interest of the digital human.

According to the invention of claim 6, a load evaluation unit is further provided for the invention of any one of claims 1 to 5, the load evaluation unit calculating affordable voluntary contraction for a portion of interest of the digital human and evaluating load of the portion of interest using the affordable voluntary contraction as a criteria, the affordable voluntary contraction being obtained by multiplying the maximum voluntary contraction by a predetermined coefficient smaller than 1.

According to the invention of claim 7, in the invention of claim 6, the load evaluation unit separates ratios of the loads acting on the portions of interest in the digital human to the affordable voluntary contraction into a plurality of levels and displays the portions of interest in the digital human with colors corresponding to the levels.

According to the invention of claim 8, a result storage is further provided for the invention of any one of claims 1 to 7, the storage storing a result from the calculation by the load calculator.

The invention of claim 9 is a product design evaluation program which is executed by a computer and locates a virtual model based on a design of a product including a movable portion and a digital human moving the movable portion of the virtual model of the product in a virtual space generated by the computer to evaluate validity of design of the product based on movement of the digital human, the program causing the computer to implement: a data synthesizing unit connecting the movable portion of the virtual model of the product and the digital human and specifying the movement trajectory of the movable portion; and a load calculator calculating load acting on a portion of interest in the digital human when the movable portion is moved along the movement trajectory.

### Effect of the Invention

According to the configurations of the inventions of Claims 1 and 9, the movable portion of the product is connected to the digital human, and the load acting on each portion of the digital human when the movable portion is moved along the movement trajectory of the movable portion is calculated. This makes it possible to evaluate the load on the user who is using the product having the movable portion and therefore implement evaluation of the design of the product including the movable portion.

According to the configuration of the invention of claim 2, the mass of the movable portion can be set. This can implement mass design facilitating the user's use by changing the mass of the movable portion.

According to the configuration of the invention of claim 3, the movement trajectory of the movable portion can be set. This enables product design facilitating the user's use by changing the movement trajectory.

According to the configuration of the invention of claim 4, the ratio of load to the maximum voluntary contraction of each portion in the digital human is evaluated for the workability degrees, and the workability degrees are distinctively displayed on the monitor unit. It is therefore possible to obviously recognize the workability in using the movable portion of the product at a glance and easily evaluate the validity of the design concerning the usability.

According to the configuration of the invention of claim 5, the change in load of each portion of interest in the digital human at each position on the movement trajectory is displayed in the graph diagram. It is therefore possible to focus on the portion subjected to large load and modify a part of the movement trajectory, thus contributing to laborsaving of the design work.

According to the configuration of the invention of claim 6, the load of each portion is evaluated using the affordable voluntary contraction smaller than the maximum voluntary contraction as a criterion. Accordingly, the validity of the design of the product can be evaluated in terms of force in such a range that the product can be comfortably used. This can implement evaluation close to the usability of the user who is actually using the product.

According to the configuration of the invention of claim 7, the color of each portion of interest in the digital human is changed according to the magnitude of the load thereof. It is therefore possible to obviously recognize the magnitude of load acting on each portion at a glance and intuitively understand the validity of the design of the product and usability of the product.

According to the configuration of the invention of claim 8, the results of calculation by the load calculator can be stored. It is therefore possible to present the results of calculation at real time with the movement of the digital human along the movement trajectory by previously calculating loads along the moving trajectory and using the stored result of calculation for display on the monitor unit.

### Brief Description of Drawings

FIG. 1 is a block diagram showing an embodiment.
FIG. 2 is a diagram showing a relation between joint angle and maximum voluntary contraction and a relation between the joint angle and joint passive resistance.
FIG. 3 is a view showing an example of a digital human used in the embodiment.
FIG. 4 is a diagram showing an example of evaluation result in the embodiment.
FIG. 5 is a view showing a screen example of the embodiment.
FIG. 6 is a diagram showing relations among the joint angle, maximum voluntary contraction, affordable voluntary contraction, and joint passive resistance.
FIG. 7 is a view showing a screen example in the embodiment.
FIG. 8 is a view showing a screen example in the embodiment.
FIG. 9 is a view showing a screen example in the embodiment.
FIG. 10 is a view showing a screen example under another condition in the embodiment.
FIG. 11 is a view showing a screen example under another condition in the embodiment.
FIG. 12 is a view showing a screen example under another condition in the embodiment.

### Mode for Carrying out Invention

A product design evaluation system explained below is configured to evaluate the validity of the design of a product by locating a digital human as a virtual human body model together with a virtual model of the product in a virtual space displayed as a three-dimensional computer graphic image formed using a computer such as a personal computer and causing the digital human to use the product in the virtual space. The product design evaluation system is therefore implemented by a computer and an application program executable in the computer.

The target product can be selected from various types of facilities and equipment including custom kitchens, bathroom vanities, toilets, bathtubs, washing machines, refrigerators, and electronic microwave ovens. As for a custom kitchen, for example, the product design evaluation system can be used to evaluate the difference in usability related to the movement trajectory of a movable shelf of a hanging cupboard which includes the movable shelf capable of being drawn out obliquely downward. As for a bathtub, the product design evaluation system can be used to evaluate how easy a user can enter the bathtub in relation to the difference in height dimension from the washing floor to the edge of the bathtub. Alternatively, as for a bathroom vanity, the product design evaluation system can be used to evaluate the usability related to the positions of a drawer and a mirror. As for the washing machine, the product design evaluation system can be used to evaluate the usability related to the height and opening direction of the door.

The points in evaluating the validity of the design of a product include a point of evaluating whether the user can conduct the movement of using the product. Specifically, it is necessary to evaluate whether the movement accompanied to the work of using the product is within a joint range of motion and whether user's muscular load during the movement of using the product is within an allowable range. The allowable range of muscular load needs to be a muscular load not more than 30% of maximum voluntary contraction (MVC) because it is required that the movement of using the product is easily performed. Such an allowable range is referred to as 30% MVC. On the other hand, the lower limit of the muscular load is a muscular load enough to move a joint and is therefore limited by joint passive resistance (JPR).

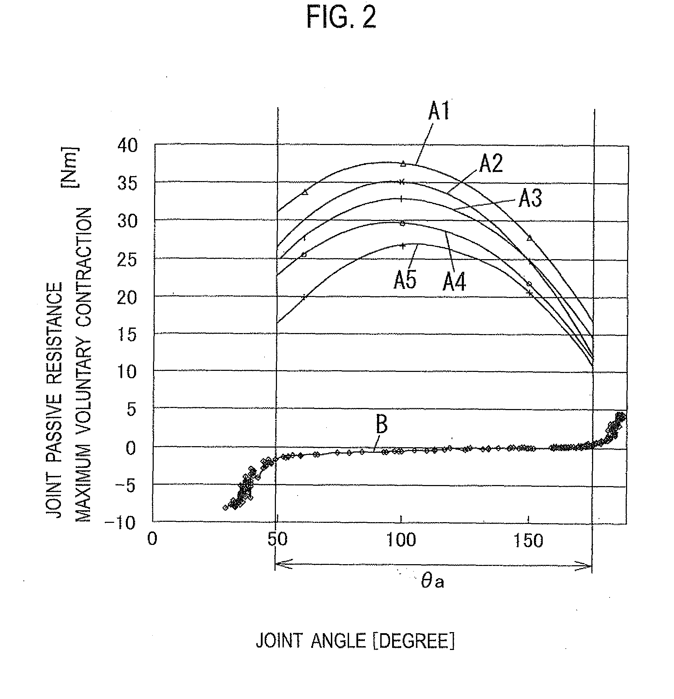

FIG. 2 shows examples of changes in the maximum voluntary contraction (curves A1 to A5) and the joint passive resistance (a curve B) with the joint angle. Small joint angle refers to flexion, and large joint angle refers to extension. As shown in FIG. 2, the joint passive resistance (curve B) changes at both ends of the joint range of motion but can be considered substantially constant in the middle of the joint range of motion regardless of the joint angle.

As described above, since the joint passive resistance greatly changes at both ends of the joint range of motion, it is not preferable that the movable portion of the product is moved using the both ends of the joint range of motion. Accordingly, in this embodiment, the region of the joint range of motion other than the both ends is referred to as an allowable joint angle range θa.

On the other hand, the maximum voluntary contraction (A1 to A5) changes with the joint angle. The curves A1 to A5 indicate maximum voluntary contractions at the ages of 40, 50, 60, 70, and 80 years, respectively and show that the maximum voluntary contraction tends to decrease with aging. In order to provide a product that elderly people can use, it is necessary that the product is designed so that the upper limit of the muscular load during use of the product is in the allowable range calculated from the maximum voluntary contraction at the age of 80 years, for example.

In this embodiment, in order to evaluate the validity of the design of the product using the digital human, the digital human is caused to perform the movement of using the product, and the joint passive resistance and maximum voluntary contraction during the movement are calculated. As described above, the criterion for the load acting on the human body performing the movement of using the product takes into consideration the maximum voluntary contraction as well as the joint passive resistance.

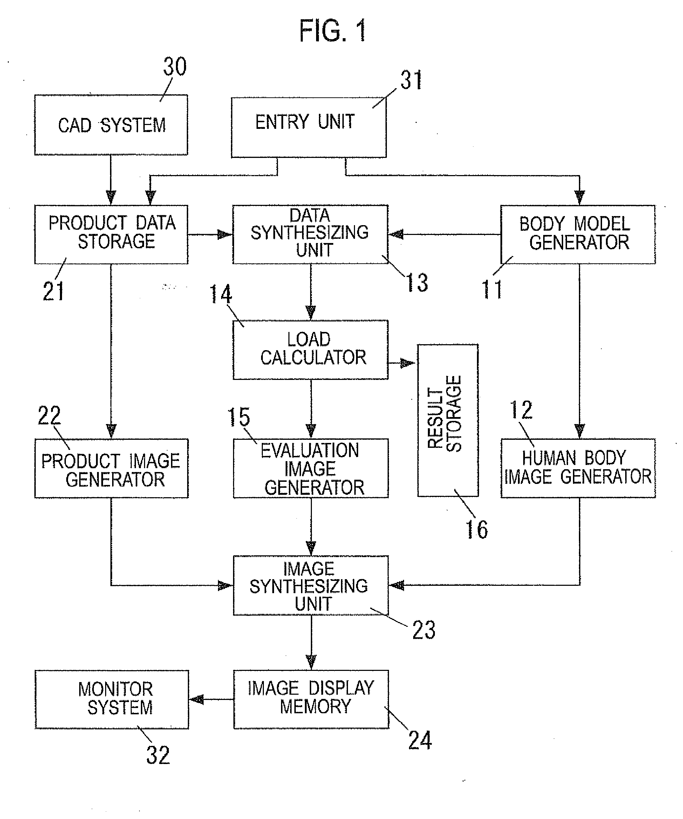

As will be understood from the above description, in this embodiment, it is necessary to locate a virtual model of the product in a virtual space where the digital human is located. Since the virtual model of the product is necessary to reflect the design of the product, as shown in FIG. 1, design data (data concerning the shape and dimensions) of the product is acquired from a CAD (computer aided design) system 30 used by a designer of the product.

In the virtual space, the digital human is caused to perform the movement of using the virtual model of the product. Accordingly, if the product includes a movable portion, the product design evaluation system requires, in addition to the design data of the product obtained from the CAD system 30, movement information representing positions of the both ends of the range of motion of the movable portion and mass information concerning the mass of the movable portion. The movement information and mass information are inputted by the designer using an entry unit 31 based on a required specification. In other words, the mass of the movable portion is variable, and the input unit 31 includes a function as a mass entry unit. Moreover, as for the movement trajectory of the movable portion, only the constraints thereof are included in the movement information so that the movement trajectory can be changed. Accordingly, the product design evaluation system can evaluate a change in muscular load due to a change in movement trajectory. The movement trajectory can be changed through the entry unit 31, which includes a function as a trajectory entry unit. The design data, movement information, and mass information are stored in a product data storage 21 as product model data. The product data storage 21 is composed of a hard disk drive unit, for example.

The product design evaluation system includes a product image generator 22 for screen display using the product model data stored in the product data storage 21. The product image generator 22 reads the product model data from the product data storage 21 and generates three-dimensional image data of the product for screen display (hereinafter, referred to as product image data).

The product image data generated by the product image generator 22 is stored in an image display memory 24 via an image synthesizing unit 23. Based on the product image data stored in the image display memory 24, the virtual model of the product is displayed on a screen of a monitor unit 32 as a three-dimensional image. Herein, the position, orientation, and size of the virtual model of the product in the virtual space displayed on the screen of the monitor unit 32 can be properly changed by an operation of the entry unit 31. Since the virtual model of the product in the virtual space is a three-dimensional image, the virtual model can be changed in position and size in the virtual space and can be also changed in orientation by changing the position of the viewpoint.

On the other hand, the digital human is used to simulate the movement of using the virtual model of the product displayed on the screen of the monitor unit 32 based on the product image data and to evaluate the muscular load accompanied with the change in posture due to the movement. The three-dimensional image data for displaying an image of the digital human (hereinafter, referred to as "human body image data" is generated in a body image generator 12 separately from the product image data.

The evaluation of the validity of the product design needs to take into consideration body conditions of a user who will really use the product. Accordingly, it is configured that various body conditions of the user can be set by the entry unit 31. As the body conditions, the height, weight, age, gender, and the presence or the kind of physical disability can be inputted.

The body conditions of the digital human inputted from the entry unit 31 are given to a body model generator 11, which then generates data of the digital human according to the inputted body conditions (hereinafter, referred to as "body representation data") . The digital human is a human body model which represents a human body with segments corresponding to a skeleton and joints corresponding to articular joints. The length dimensions of the segments, the ranges of motion of the joints, and the like are determined based on the body conditions inputted from the entry unit 31.

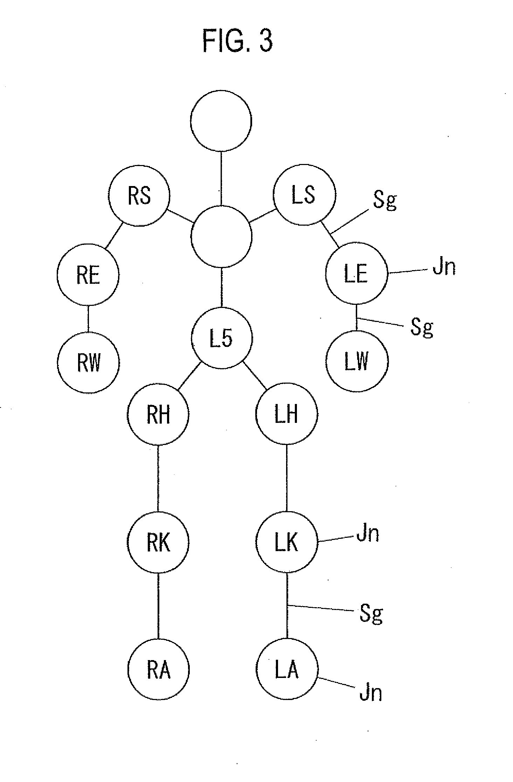

The digital human Hm of this embodiment, as shown in FIG. 3, is represented by a plurality of segments Sg (14 segments in the example of the drawing) corresponding to a skeleton of a human body and a plurality of joints Jn corresponding to articular joints of the human body (13 joints in the example of the drawing). In a displayed image, skin (surface properties) is mapped so as to form an appearance like a human body by a human body image generator 12. The joints Jn correspond to articular joints, and the segments Sg correspond to the skeleton and also correspond to a group of muscles stretching and contracting due to extension and flexion of articular joints. In this case, each segment Sg usually refers to a muscle group including not only a single type of muscle but a plurality of types of muscles composed.

The digital human Hm shown in FIG. 3 includes 13 joints Jn (represented by circles), and 11 joints thereamong are given names. Specifically, the joints Jn represent a left ankle (LA), a left knee (LK), a left hip (LH), a right ankle (RA), a right knee (RK), a right hip (RH), a loin (L5), a left shoulder (LS), a right shoulder (RS), a left elbow (LE), a right elbow, (RL), a left wrist (LW), and a right wrist (RW) so as to correspond to a human being in a real space. In this embodiment, it is assumed that the product is used with hands, and the movable portion of the product is assumed to be operated with the left or right wrist (LW or RW). The aforementioned numbers of the segments Sg and joints Jn are just examples.

The segments Sg have an attribute of length, which is determined by the height. Specifically, since the average length of each bone is known in relation to the height, when the height is inputted from the entry unit 31, lengths of the segments Sg are automatically determined by the body image generator 12.

The joints Jn have attributes of an angle (an angle in a coordinate system set to the digital human Hm) and a range of motion. As for the angle, the angle of each joint Jn of the digital human Hm standing upright is used as an initial value. The initial value of the angle changes with aging. As the muscles supporting joints decreases in strength with aging, the angles between the segments Sg supported by some of the joints Jn corresponding to the knees and loin are changed (for example, if a straight-extended portion bends, the angle changes from about 180 degrees so as to become smaller).

Using the initial value of each angle, it is possible to display the state where the loin and knees are bent from a standing initial posture, for example. Similarly, for the range of motion of the joints Jn is reduced with aging, the accessible range of the feet and hands can be expressed in consideration of the range of motion of each joint Jn.

As described above, the body image generator 12 determines the length of each segment Sg constituting the digital human Hm and the initial value of the angle of each joint Jn based on the body conditions inputted from the entry unit 31. Moreover, when there is an entry of the presence and the kind of physical disability, the posture of the digital human Hm and the range of motion are adjusted according to the disabled body part. As for the gender, since the joint range of motion is generally wider in women, the range of motion of each joint Jn is adjusted when the gender is specified.

The body representation data generated at the body model generator 11 is inputted to the data synthesizing unit 13 together with the product data stored in the product data storage 21. In the data synthesizing unit 13, one of the joints Jn is connected to the movable portion of the product according to an instruction from the entry unit 31. Moreover, the movement trajectory of the connected joint Jn when the movable portion is moved can be specified by the entry unit 31. Since the joint Jn is connected to the movable portion, specifying the movement trajectory of the joint Jn is the same as specifying the movement trajectory of the movable portion of the product.

For example, when the movable portion of the product is connected to the joint Jn corresponding to the right wrist (RW) of the digital human Hm, the movable portion moves following the movement trajectory of the connected joint Jn, and the movement trajectory of the connected joint Jn is therefore coincident with the movement trajectory of the movable portion. Moreover, there is a group of rules set so that the angles of the other joints change in coordination according to the change in position of the connected joint Jn. The angles of the other joints Jn are determined by checking the group of rules each time the joint Jn connected to the movable portion of the product changes in position. The group of rules prescribing the coordination relationship among the joints Jn includes a restriction preventing the digital human Hm from assuming an improper posture.

The movement trajectory given by the data synthesizing unit 13 as described above enables calculation of load acting on the digital human Hm due to the mass of the movable portion of the product when the movable portion is moved and calculation of the angle of each joint Jn of the digital human Hm when the movable portion is moved. Herein, the load acting on the digital human Hm due to the movable portion of the product when the movable portion is moved is considered to act on the joint Jn connected to the movable portion.

The load and the angle of each joint Jn calculated by the data synthesizing unit 13 are inputted to a load calculator 14. In the load calculator 14, the relations between the maximum voluntary contraction and joint angle and between the joint passive resistance and joint angle as shown in FIG. 2 are previously registered as data tables or approximate arithmetic equations (for example, the relations are approximated by a parabola convex downward and expressed by a quadratic function). In the load calculator 14, the angle of each joint Jn (or the articular joint angle) when the movable portion of the product is moved is calculated, and the maximum voluntary contraction and joint passive resistance corresponding to the calculated angle are calculated using the aforementioned relations.

In the load calculator 14, the value corresponding to the muscular load acting on each segment Sg is calculated based on the angles of the joints Jn and the mass of the movable portion. The value corresponding to the muscular load is a torque acting on an articular joint flexed and extended by stretch and contraction of muscles. Herein the torque refers to a moment of the force acting around the joint. The torque acting on the joint of interest is calculated in consideration of the resultant of force acting around the joint due to the own weight and force acting due to the weight of the product. In the load calculator 14, therefore, the torque acting on each joint Jn is calculated based on the posture of the digital human Hm and the load acting on each joint Jn.

The torque around each joint Jn calculated by the load calculator 14 is considered to reflect the muscular load of muscles flexing and extending the joint Jn. Accordingly, by calculating the torque acting on each joint Jn, the muscular load corresponding to each segment Sg can be evaluated.

The maximum limits of torques acting on the joints Jn are different from each other and are determined by maximum voluntary contractions of the group of muscles concerning the flexion and extension of the joint Jn. In the load calculator 14, therefore, the torque acting on each joint Jn is set to a plurality of levels (three levels in this embodiment) based on the maximum voluntary contraction according to the angle of the joint Jn (or articular angle). Specifically, the torque is set to one of the three high, intermediate, and low levels based on the ratio of the torque to the maximum voluntary contraction (MVC). Moreover, the torque acting on each joint Jn (or muscular load) is evaluated with "easy" for the low level of torque having a lowest ratio to the maximum voluntary contraction, "difficult"" for the intermediate level, and "very difficult" for the highest level.

The computing processing at the load calculator 14 is performed at a plurality of calculation points set on the movement trajectory of the joint Jn connected to the movable portion of the product. Such computing processing can be performed at real time while the joint Jn of the digital human Hm is moved along the movement trajectory. In this embodiment, however, when the movement trajectory is determined, the computing processing is previously performed at the plurality of calculation points set on the movement trajectory, and the results of the computing processing are stored in a result storage 16. The results of the computing processing can be therefore always read out from the result storage 16. As described later, at the time of displaying the results from the computing processing on the monitor unit 32, the result display can be performed as if the processing is performed at real time by reading out the results of the computing processing performed in advance.

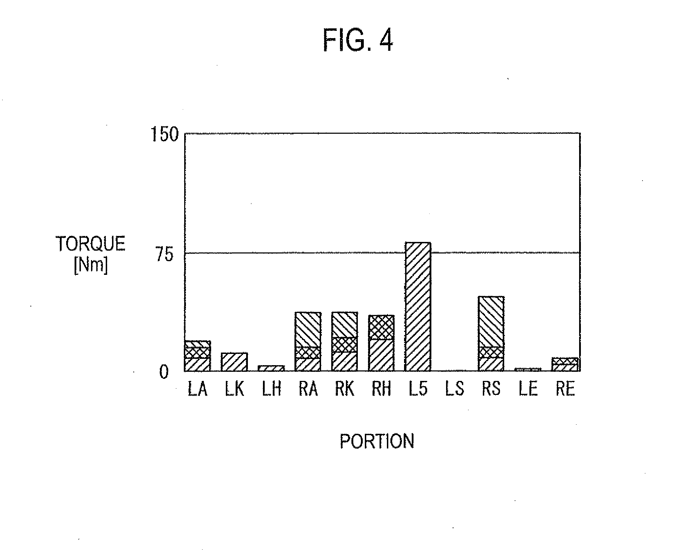

The computing results of the load calculator 14 are inputted to an evaluation image generator 15, where evaluation image data in the form of a bar chart showing the three levels of "easy", "difficult", and "very difficult" is generated according to the magnitude of the torque acting on each joint Jn as shown in FIG. 4. The evaluation image data includes the value of the torque acting on each joint Jn and the level set for the joint Jn. In the data of torque shown in FIG. 4, the torque levels are classified based on actual measurement data obtained for each age.

Specifically, "easy", "difficult", and "very difficult" are represented in green, yellow, and red, respectively. The magnitude of torque calculated for each joint Jn is represented by length (height) of a bar related to the joint Jn of interest. If the level of the torque is "easy", the entire bar is represented in green. If the level of the torque is "very difficult", the upper end of the bar is represented in red, the range of torque of the "difficult" level is represented in yellow; and the range of torque of the "easy" level is represented in green.

In other words, when the torque acting on each joint Jn is of the "easy" level, the related bar is represented in green. When the torque acting on the joint Jn is of the "difficult" level, the related bar is represented in two colors of green and yellow. When the torque acting on the joint Jn is of the "very difficult", the related bar is represented in three colors of green, yellow, and red. In FIG. 4, the green region is indicated by hatching from upper right to lower left; the yellow region is indicated by cross-hatching; and the red region is indicated by hatching from upper left to lower right. The evaluation image displayed based on the evaluation image data can therefore provide very obvious recognition whether the torque acting on each joint Jn is appropriate.

In the evaluation image generator 15, image data of a graph diagram in which the torques obtained at the plurality of positions along the movement trajectory by the load calculator 14 are arranged on a time axis and image data in which the options for selecting the joint Jn the time change in torque of which is to be displayed are also generated. This makes it possible to display the time change in torque acting on each joint Jn when the movable portion of the product is moved along the movement trajectory. The time taken for each joint Jn to move between the both ends of the movement trajectory is about several tens seconds at maximum. Accordingly, the time axis of the graph diagram showing the time change in torque just should have a length corresponding to about several tens seconds at maximum (which is normally about 10 seconds). The absolute value of the time is not important in this graph diagram, and the moving distance along the movement trajectory just should be converted to time long enough not to feel strange.

The evaluation image data (including the above-described image data of the graph diagram or the image data for selection if necessary) is inputted to an image synthesizing unit 23 together with the product image data and body image data. The evaluation image data is adjusted so as to be superimposed and displayed on the screen of the monitor unit 32 by the image synthesizing unit 23 and is stored in an image display memory 24 together with the product image data and body image data.

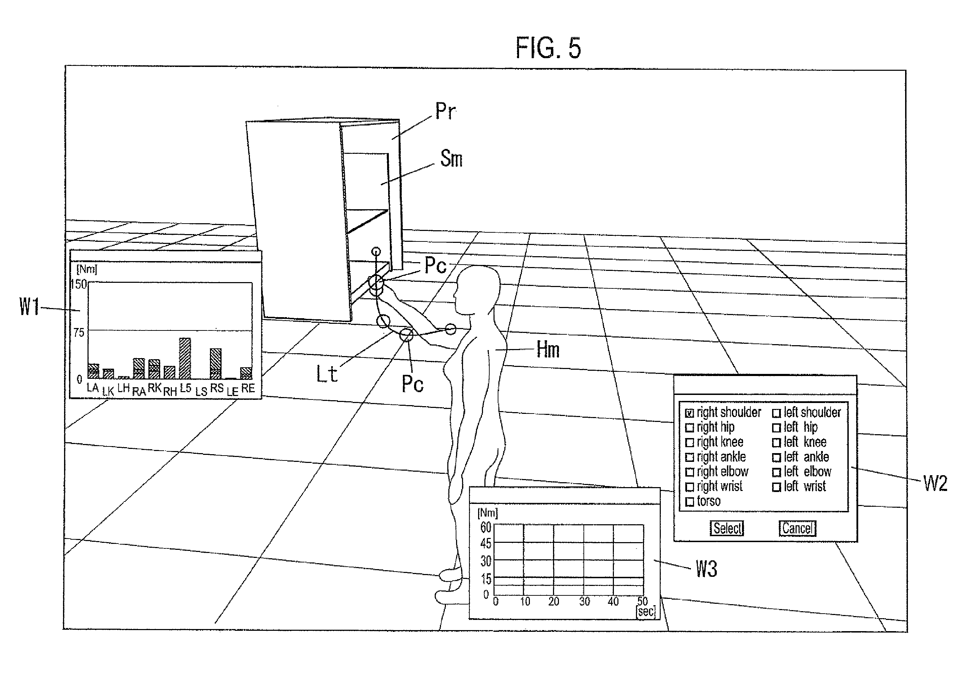

By the above-described configuration, an image like as shown in FIG. 5, for example, is displayed on the monitor unit 32. In the example shown in the drawing, a product Pr is assumed to be a hanging cupboard which is provided with a movable shelf Sm at the bottom as the movable portion. The movable shelf Sm is connected to the joint Jn corresponding to the right wrist (RW), and a movement trajectory Lt concerning the right wrist (RW) is specified by the instruction from the entry unit 31.

The movement trajectory Lt can be freely deformed by specifying a pointer and changing the position of the pointer as known as the way of drawing a Bezier curve or a spline curve in drawing application programs. In this embodiment, the positions of the both ends of the movement trajectory Lt are registered in the product data storage 21 so as not to be changed without another instruction.

After the movement trajectory Lt is set, upon the instruction from the entry unit 31 to start calculation, the calculation is performed to obtain torques acting on joints Jn other than the joint Jn connected to the right wrist when the joint Jn (wrist (RW)) is positioned at a plurality of calculation points P. The calculation result is displayed as a window W1 on the screen of the monitor unit 32. FIG. 5 also shows a window W3 displaying the time change in torque acting on the joint Jn of interest and a window W2 presenting options used to select the joint Jn of interest. When the desired joint Jn is selected from the options presented in the window W2, the time change in torque acting around the selected joint Jn when the movable portion (movable shelf Sm) moves along the specified movement trajectory Lt is shown in the window W3.

In the image shown in FIG. 5, by properly giving the body conditions of the digital human Hm through the entry unit 31, the muscular load during use of the product under various body conditions can be checked without producing the real product. Accordingly, the product design evaluation system can be used as a tool for designing and developing universal design products taking various body conditions into consideration.

In the aforementioned example, the muscular load acting on a certain portion of the digital human Hm is evaluated in terms of the ratio thereof to the maximum voluntary contraction of the group of muscles which is calculated from the angle of each joint Jn. However, the muscular load may be evaluated using the affordable voluntary contraction defined based on the maximum voluntary contraction as a criterion instead of the ratio of muscular load to the maximum voluntary contraction. The affordable voluntary contraction is a value obtained by a not-shown load evaluation unit and, for example, can be defined by multiplying the maximum voluntary force by a coefficient smaller than 1 (for example, 0.8).

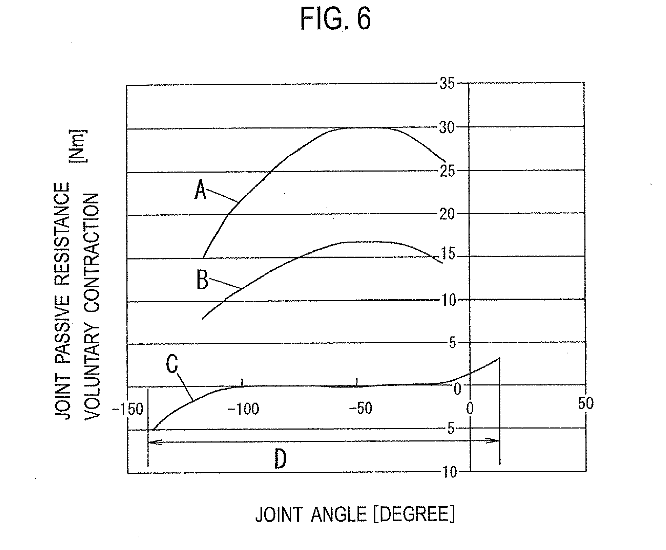

The relation between the maximum voluntary contraction and affordable voluntary contraction is like a relation between a curve A (maximum voluntary contraction) and a curve B (affordable voluntary contraction) shown in FIG. 6. In FIG. 6, a curve C represents the joint passive resistance, and D indicates a joint range of motion. Herein, the affordable voluntary contraction is set in a range of the joint range D of motion other than the both ends thereof because the muscle strength is difficult to exert around the both ends of the joint range D of motion. In short, the affordable voluntary force is set in the aforementioned allowable range θa.

By using the affordable voluntary contraction set smaller than the maximum voluntary contraction as the criteria, it is possible to evaluate muscular load closer to the actual use situation. In other words, it is not realistic that the muscular load would reach the maximum voluntary contraction during actual use of the product. Accordingly, the affordable voluntary contraction is properly set and determined to be the upper limit of the muscular load, thus achieving realistic evaluation.

In order to determine the affordable voluntary contraction, the maximum voluntary contraction is measured for a real subject about ten times at an angle within the joint range of motion, and the average thereof is used to determine the coefficient of the affordable voluntary contraction. Alternatively, similar measurement is carried out for a real subject at a plurality of angles within the joint range of motion to determine the coefficient at each angle and define the coefficient for each angle, or the average of the measurement values at the plurality of angles is used to define a coefficient used for all of the angles.

For each joint Jn of interest, the affordable voluntary contraction of the joint Jn is calculated for each angle of the joint Jn according to each age. The calculated data is stored as a data table. Accordingly, the combination of the age, angle, and affordable voluntary contraction is prescribed for each joint Jn of interest as the data table. If the age, the joint angle, and the muscular load are determined for each joint Jn, the ratio of the muscular load acting on the joint Jn to the affordable voluntary contraction can be calculated using the data table.

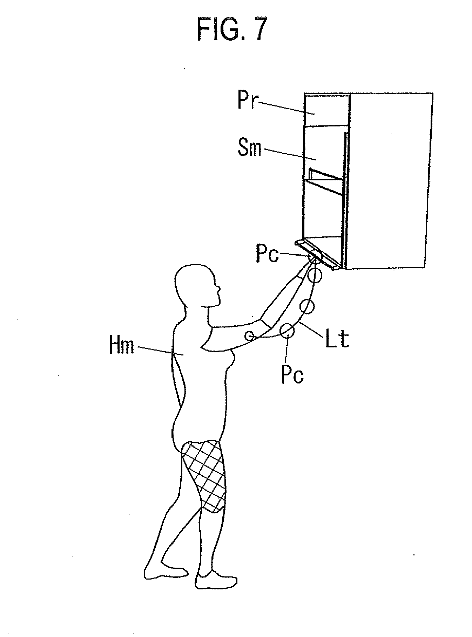

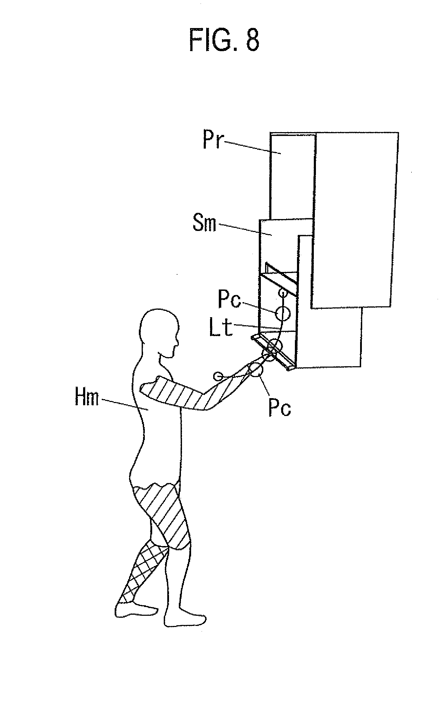

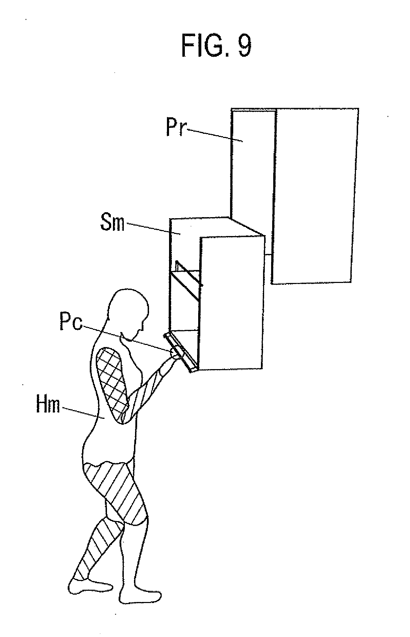

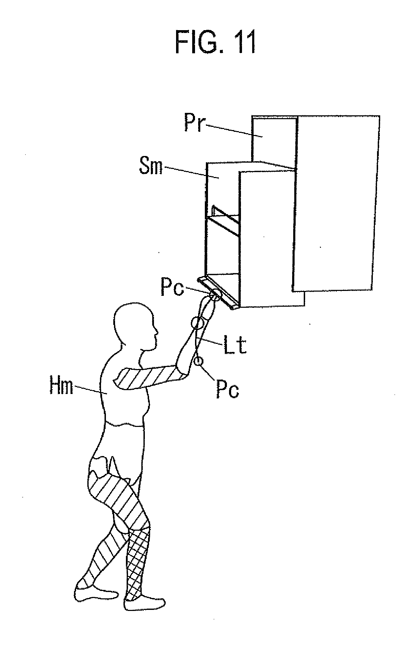

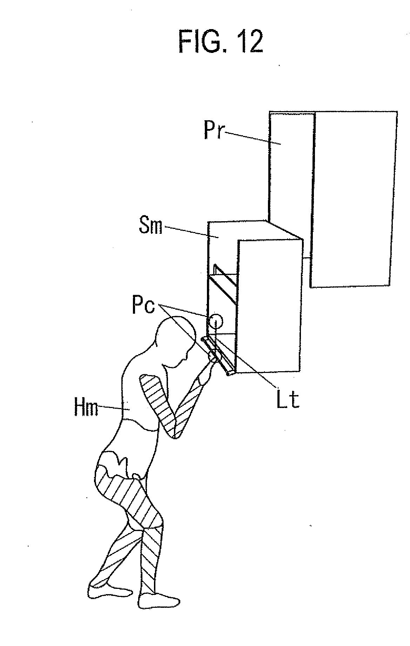

In the case of using the affordable voluntary contraction as the criterion, similarly to the case of using the maximum voluntary contraction as the criterion, the torques acting on the joints Jn of interest in the digital human Hm are set to a plurality of levels. Herein, it is assumed that the load evaluation unit (not shown) sets four levels according to the ratio of the muscular load to the affordable voluntary contraction. FIGS. 7 to 12 show an example in which the monitor unit 32 displays evaluation of the muscular load in the case of operating the movable shelf Sm provided in a cupboard as the product Pr. The load evaluation unit defines a color for each level and displays the digital human Hm with portions of interest colored with colors according to the levels thereof.

In the example shown in FIGS. 7 to 12, the degrees of muscular loads of portions of interest in the digital human Hm are represented by four colors of green (no hatching), yellow (cross-hatching), orange (right down hatching), and red (right up hatching), which are in ascending order of muscular load. The red portion then has an excessive muscular load. As will known from the comparison of FIGS. 7 to 9 or FIGS. 10 to 12, as the movable shelf Sm is drawn down, the muscular load of each portion changes, and the color of the portion changes. It is therefore possible to easily recognize the change in muscular load in a glance of the display of the monitor unit 32.

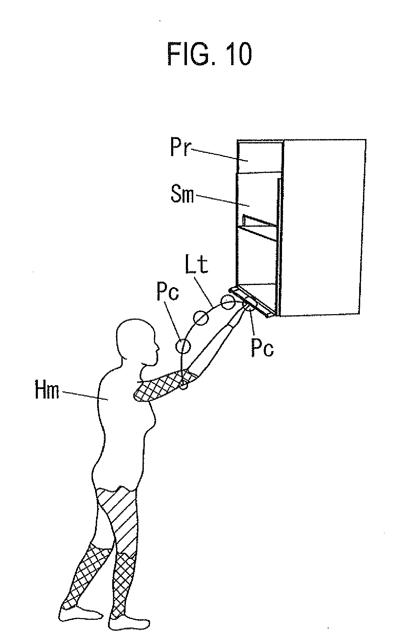

FIGS. 7 to 9 show a case where the age of the digital human Hm is set to 50 years and the movement trajectory Lt is set so that the movable shelf Sm comes down from the retracted position and then moves forward. FIGS. 10 to 12 show a case where the age of the digital human Hm is set to 70 years and the movement trajectory Lt is set so that the movable shelf Sm moves forward from the retracted position and then comes down. The validity of the design of the product can be evaluated by varying the age of the digital human Hm and movement trajectory Lt of the movable portion in such a manner.

By the way, the process from development to sales of a product requires the phases of planning, design, and sales at least. The aforementioned product design evaluation system can be used at the phases of design and sales as a tool for product development. To be specific, at the time of design, a three-dimensional virtual model of the product is generated from the design data of the product created using CAD, and the body conditions of the digital human Hm are varied for the virtual model of the product to evaluate the usability of the product according to the body conditions.

Herein, the design data of the product is not necessary to take a final form of the product and may be just a prototype of the product shown at the planning phase and given with proper dimensions. Accordingly, at the time of planning, it is desirable to create a virtual model simple enough to show the shape of the product by using a development tool creating three-dimensional data based on two-dimensional data such as an illustration drawn free hand or a photograph of a mock-up or by using a development tool composed of a drawing program including several types of samples as basic forms of the product. Using such a type of development tool at the planning phase, the three-dimensional data of the product generated at the planning can be used as a prototype at the design phase.

The three-dimensional data of the prototype is modified by an expert designer, so that three-dimensional model data close to the real product can be generated. In other words, using the development tools generating three-dimensional data from two-dimensional data or using the program generating a prototype of the product allow the planning and designing phases to be seamlessly connected.

On the other hand, in the design phase, the three-dimensional model of the designed product is used to perform the aforementioned evaluation of the product by means of the digital human Hm for evaluating the validity of the designed product. To be specific, variously setting the body conditions of the digital human Hm can facilitate the evaluating whether the product is suitable for the body conditions of interest.

Furthermore, at the sales phase, an image including the designed product and digital human Hm located in virtual space generated by a computer is displayed in a monitor screen, and the movement of the digital human using the product and the change in load acting on the body due to the movement are presented under the various body conditions of the digital human Hm, thus showing the usability of the product to the clients. In other words, the product design evaluation system visually appeals the usability of the product to allow the client to intuitively know the convenience of the product, thus contributing the sales of the product.

### Industrial Applicability

According to the present invention, for evaluating the design of a product of housing-related equipment, the designed product is presented with a digital human in a virtual space presented as a three-dimensional computer graphic image. The digital human can be caused to use the product, and the design of the product can be evaluated focusing on load acting on each portion of the digital human.

## Claims

1. A product design evaluation system which locates a virtual model based on a design of a product including a movable portion and a digital human moving the movable portion of the virtual model of the product in a virtual space generated by a computer to evaluate the validity of the design of the product based on movement of the digital human, the system comprising:
a data synthesizing unit connecting the movable portion of the virtual model of the product and the digital human and specifying the movement trajectory of the movable portion; and
a load calculator calculating load acting on a portion of interest in the digital human when the movable portion is moved along the movement trajectory.

2. The product design evaluation system according to claim 1, further comprising a mass entry unit setting a mass of the movable portion of the virtual model of the product.

3. The product design evaluation system according to claim 1 or 2, further comprising a trajectory entry unit specifying the movement trajectory of a portion connecting the movable portion of the virtual model of the product and the digital human.

4. The product design evaluation system according to any one of claims 1 to 3, further comprising:
an evaluation image generator generating an image of a graph chart distinctively showing loads acting on portions of interest of the digital human for each portion and showing workability degrees each calculated from the ratio of the magnitude of the load to the maximum voluntary contraction at each portion; and
a monitor unit displaying the graph chart generated by the evaluation image generator.

5. The product design evaluation system according to claim 4, wherein the evaluation image generator generates an image of a graph chart showing a change in load at each position on the movement trajectory for a portion selected from the portions of interest of the digital human.

6. The product design evaluation system according to any one of claims 1 to 5, further comprising a load evaluation unit calculating affordable voluntary contraction for a portion of interest of the digital human and evaluating load of the portion of interest using the affordable voluntary contraction as a criteria, the affordable voluntary contraction being obtained by multiplying the maximum voluntary contraction by a predetermined coefficient smaller than 1.

7. The product design evaluation system according to claim 6, wherein the load evaluation unit separates ratios of the loads acting on the portions of interest in the digital human to the affordable voluntary contraction into a plurality of levels and displays the portions of interest in the digital human with colors corresponding to the levels.

8. The product design evaluation system according to any one of claims 1 to 7, further comprising a result storage storing a result from the calculation by the load calculator.

9. A product design evaluation program which is executed by a computer and locates a virtual model based on a design of a product including a movable portion and a digital human moving the movable portion of the virtual model of the product in a virtual space generated by the computer to evaluate validity of design of the product based on movement of the digital human, the program causing the computer to implement:
a data synthesizing unit connecting the movable portion of the virtual model of the product and the digital human and specifying the movement trajectory of the movable portion; and
a load calculator calculating load acting on a portion of interest in the digital human when the movable portion is moved along the movement trajectory.
